# EUROPEAN PATENT APPLICATION

(11) **EP 1 750 119 A1**
(43) Date of publication of application: **07.02.2007**
(21) Application number: 05107264.3
(22) Date of filing: 05.08.2005
(51) Int. Cl.: G01N 24/08, C07B 57/00

(54) **Novel chiral derivatizing reagent for the determination of enantiomeric excesses**

(71) Applicant: Institut Catala D'Investigacio Quimica, 43007 Tarragona (ES); ICREA, Institució Catalana de Recerca I Estudis Avançats, Passeig Lluís Companys, 23 Barcelona CP 08010 (ES)
(72) Inventor: Pericàs Brondo, Miquel A., 43007, TARRAGONA (ES); Jimeno Mollet, Cirili, 43007, TARRAGONA (ES); Vidal i Ferran, Anton, 43007, TARRAGONA (ES); Rodríguez Escrich, Sergi, 43007, TARRAGONA (ES); Popa Madeleine, Dana, 43007, TARRAGONA (ES)
(74) Representative: Barlocci, Anna

(57) **Abstract**

A method for the determination of the enantiomeric composition of a chiral compound comprising (a) derivatising said chiral compound with a enantiomerically and diastereomerically pure compound of general formula I and (b) analysing the resulting mixture by an analytic technique. 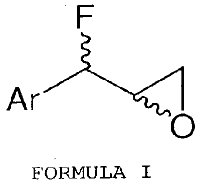 wherein Ar is an optionally substituted aromatic or heteroaromatic group.

## Description

### Field of the invention

The present invention relates to a method for the determination of the enantiomeric composition of a chiral compound by using a novel chiral derivatising reagent. More specifically, the present invention is directed to a method for the determination of the enantiomeric composition of a chiral compound through its derivatisation with a compound of general formula I and subsequent analysis of the resulting mixture.

### Background art

Since enantiopure compounds are increasingly important in the chemical and pharmaceutical sciences due to their particular properties, and especially because one enantiomer usually behaves differently than its counterpart when interacting with a biological system, the need to develop fast and efficient methods to determine the enantiomeric purity of a synthetic scalemic mixture (in other words, resolution methods) is in demand (see for example Chirality in Industry, I and II, A. N. Collins, G. N. Sheldrake, J. Crosby, Eds. John Wiley and Sons, 1992, Chichester). The term "enantiomeric purity", or alternatively "enantiomeric excess" (abbreviated "ee"), as used herein is defined as: |F(+) - F(-)|, wherein F(+) refers to the mole or weight fraction of the (+)-enantiomer and F(-) refers to the mole or weight fraction of the (-)-enantiomer. Correspondingly, the "percent enantiomeric purity" or alternatively, the "percent enantiomeric excess" is defined as 100x|F(+)-F(-)|.

In the background art, two basic approaches have been described for the chromatographic or NMR resolution of enantiomers: direct methods and indirect methods.

The direct approach requires no chemical derivatisation prior to the separation process. Before the mid-1960s, the enantiomeric purity of a chiral molecule was usually directly assessed by measuring the optical rotation and/or circular dichroism (CD). Said methods seemed the simplest direct strategy to adopt for the rapid determination of enantiomeric composition, as it implies the direct detection of the signature property of chiral molecules, namely their ability to rotate plane polarized light. The measurement of optical rotation and/or circular dichroism (CD) has three main drawbacks that make it difficult to employ in a practical manner: relatively low sensitivity; a correspondingly low tolerance of impurities, particularly chiral ones; and the fact that optical rotation does not vary linearly with enantiomeric composition, so that the optical purity may not be equivalent to the enantiomeric purity. The term "optical purity" as used herein refers to the ratio of the observed optical rotation of a sample consisting of a mixture of enantiomers to the optical rotation of one corresponding pure enantiomer. Correspondingly, the "percent optical purity" is defined as 100 x optical purity.

Chiral chromatographic methods (HPLC, GC) have simplified and quickened the direct analysis of many products (see for example: M.E. Anderson, D. Aslan, A. Clarke, J. Roeraade, G. Hagman, J. Chromat. 2003, 1005, 83; V. A. Davankov, Pure Appl. Chem. 1997, 69, 1469). This approach involves the direct resolution through reversible diastereomeric association between a chromatographic chiral environment and solute enantiomers. The main drawbacks of this kind of methods are that chiral stationary phases (CSP) are expensive and much more sensitive to physical and chemical aggression than regular chromatography columns. Moreover, their use always implies trial-and-error iterations to optimize the phase and separation conditions, whenever it is possible to separate the compounds.

On the other hand, two general groups of indirect approaches have been described in the background art. The first approach involves those procedures wherein the derivatisation of the substrate whose absolute configuration is studied is not necessary. The sample (i.e., a pure enantiomer) is analyzed by NMR in a chiral environment that is provided by a chiral shift reagent (in general, chiral lanthanide complexes) (see for example patents US5736411, JP2002020358 and US3950135) or by the addition of a chiral solvating reagent (CSA) (see for example ES2187269 and IT1249016) to a non-chiral standard NMR solvent. In this approach, there is no covalent linkage between the substrate and the chiral "reagent", and this advantage is the origin of its main limitation: The chiral environment produces generally very small differences in chemical shifts for the two enantiomers whose NMR are very similar.

The second approach involves derivatisation of the substrate (i.e., a pure enantiomer) with an optically pure chiral derivatising reagent (CDA), i.e. the formation of diastereomers followed by their separation by chromatography or their NMR analysis in an achiral environment. The diastereomeric composition determined can be directly related to the enantiomeric composition of the original mixture. Through said indirect techniques, the chiral environment is provided by the CDA, which acts as auxiliary reagent. Advantageously, the association with the substrate is covalent and leads to much-greater differences in chemical shifts than those obtained when CSAs are used. Moreover, the chromatographic separation of a diastereomeric pair obtained via the CDA indirect technique is simpler to perform and often has better resolution than the separation of the corresponding enantiomeric pair with a direct method, mainly because chromatographic conditions are much easily optimized.

Therefore, among the different approaches described in the background art for the determination of the enantiomeric composition of an unknown sample of a chiral compound, the CDA approach is nowadays the method of choice for a reliable determination. See, for example D. Parker, Chem. Rev. 1991, 91, 1441; R. Rothchild, Enantiomer 2000, 5, 457; M. G. Finn, Chirality 2002, 14, 534.

Advantageously, said methods can be adapted to several common techniques such as NMR or chromatography with no need of any modification. In some cases it is even possible to determine the absolute configuration of the new compound (for a review, see J. M. Seco, E. Quiñoá, Riguera, R. Chem. Rev. 2004, 104, 17).

It is generally admitted that a chiral derivatising reagent should fulfill the following requisites in order to achieve general interest:
(a) The CDA must be enantiomerically pure. The presence of a small quantity of the opposite enantiomer of CDA will reduce the observed enantiomeric excess value;
(b) Straightforward preparation to make it easily accessible to most chemists;
(c) Fast and clean reactivity towards the substrate to be analyzed. The chiral compound and the chiral derivatising reagent must possess an easily derivatisable and compatible functional group;
(d) Absence of kinetic resolution due to differential reaction rates of the substrate enantiomers with CDA, in order to ensure that the enantiomeric ratio determined corresponds to that of the original sample; and
(e) The stereochemical integrity of the derivatisation reaction and any further treatment or purification step must be rigorously established. There must be no possibility of racemisation or accidental enrichment accompanying these processes. The term "racemisation" as used herein refers to a decrease of the enantiomeric excess of a chiral starting material. The term "enrichment" as used herein refers to an increase of the enantiomeric excess of a chiral starting material.

Moreover, the more techniques that are able to distinguish the diastereomers formed, the easier the determination will be. In this respect it is desirable that NMR-active heteroatoms, such as ¹⁹F, are embedded in the structure in addition to ¹H and ¹³C in order to facilitate the analysis by NMR techniques. Alternatively, the introduction of a chromophore enhances the detection in HPLC resolution. Finally, resolution via diastereomer formation is usually improved when the chiral centers of both the reagent and the analyte are in close proximity in the resulting diastereomer (see D. Stevenson, G.A. Williams, 1988, Stevenson D and Wilson ID (eds). Chiral Separations. Plenum Press, New York).

Although many chiral derivatising reagents have been described in the background art, many of said reagents suffer inherent problems, namely the inability to react with a broad variety of substrates, the production of unstable derivatives, the poor detectability of certain derivatives or the lack of quantitative yield of the reaction. Other usual drawbacks that many chiral derivatising reagents of the background art have shown are the need to use an excess of the chiral derivatising reagent in order to avoid kinetic resolution, the need to purify the derivatives or the complexity of the corresponding method for the determination of enantiomeric compositions. It should be pointed out that the reliability of a particular CDA depends very much on the number and structural variety of the substrates of known enantiomeric composition used as test compounds to validate the reagent and the corresponding method. Thus the development of new resolution reagents with improved properties is of practical interest.

It is an object of the present invention to provide a method for the easy, fast, sensitive and reliable determination of the enantiomeric composition of a chiral compound which has broad scope and which overcomes the deficiencies of the prior art.

### Summary of the invention

It is an object of the present invention to provide a method for the determination of the enantiomeric composition of a chiral compound which overcomes the deficiencies of the prior art.

This object is achieved by the method of the present invention.

The present invention relates to a method for the determination of the enantiomeric composition of a chiral compound by using a novel chiral derivatising reagent, said chiral derivatising reagent being a compound of general formula I: 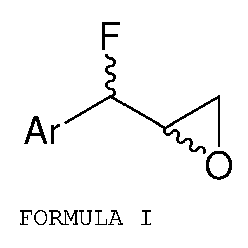 wherein Ar is an aromatic or heteroaromatic group which can be optionally substituted. The term "aromatic" as defined herein refers to a cyclic conjugated molecular entity with alternating single and double bonds whose stability (due to delocalization) is significantly greater than that of a corresponding hypothetical localized structure (Kekulé structure). The term "heteroaromatic" refers to an aromatic entity wherein al least one of the carbon atoms of the ring system has been replaced by a heteroatom.

More specifically, the present invention refers to a method for the determination of the enantiomeric composition of a chiral compound in a sample comprising:
(a) derivatising said chiral compound with a enantiomerically and diastereomerically pure compound of general formula I, so as to form the corresponding diastereomeric derivative (if the starting chiral compound was enantiopure) or diastereomeric mixture (if the starting chiral compound was a mixture of enantiomers), and
(b) analysing the resulting mixture by an analytic technique.

Advantageously, according to the method of the present invention, the diastereomeric composition determined can be directly related to the enantiomeric composition of the starting chiral compound.

In a preferred embodiment of the present invention, the derivatisation of the chiral compound with the compound of general formula I is performed in the presence of a promoter. The term "promoter" as defined herein refers to a substance that increases the rate of a reaction.

More specifically, said derivation is performed by adding a solution of the chiral compound to a solution of the compound of general formula I and the promoter. Preferably, said promoter is a Lewis acid, for example LiClO₄ or Cu(BF₄)₂. A skilled person in the art will be able to select the most suitable promoter for each particular derivatisation reaction, depending on the structure of the chiral compound to be analysed.

Depending on the particular chiral compound to be analysed, it may be necessary to heat the reaction mixture. Said heating can be a conventional heating or an irradiation, preferably a microwave irradiation. A skilled person in the art will be able to select the most suitable temperature conditions for each particular derivatisation reaction.

A particular advantage of the derivatisation reaction according to the method of the present invention is that it can be performed straightforward. Moreover, short reaction times are required.

Advantageously, the derivatisation reaction according to the method of the present invention takes place with excellent yield and with complete regioselectivity and stereoespecificity.

The chiral compound to be determined through the method of the present invention can be enantiopure (only one enantiomer present) or can be a mixture of both enantiomers in variable quantities. Each enantiomer of the chiral compound will give rise to a different diastereomer after the derivatisation reaction according to the present invention. Advantageously, it has been established that no kinetic resolution takes place during the derivatisation reaction according to the method of the present invention, ensuring that the diastereomeric composition determined can be directly related to the enantiomeric composition of the original sample.

The reaction involved in the derivatisation reaction according to the method of the present invention, namely the nucleophilic ring-opening of an epoxide, has not been described before in the context of determination of enantiomeric compositions. Surprisingly, said derivatisation reaction takes place with excellent yield, and short reaction times, with complete regioselectivity and stereoespecificity, and without kinetic resolution, as indicated above. Therefore, the nucleophilic ring-opening of an epoxide is a very suitable derivatisation reaction for the determination of enantiomeric compositions by using chiral derivatising reagents.

A further advantage of the method of the present invention is that no purification step is needed after the derivatisation reaction. A simple aqueous treatment of the reaction mixture is enough, the resulting crude being suitable for analysis according to the second step of the method of the present invention. Optionally, the diastereomeric mixture can be purified through a known purification method, for example chromatography.

Advantageously, the stereochemical integrity of the chiral centers is rigorously maintained during the derivatisation reaction according to the first step of the method of the present invention and during any further treatment or optional purification step. Likewise, the stereochemical integrity of the chiral centers is rigorously maintained during the analysis according to the second step of the method of the present invention. Therefore, no racemisation or accidental enrichment is produced during the performance of the method of the present invention, so that it can be assured that the diastereomeric ratio determined through the method of the present invention corresponds to the enantiomeric ratio of the original sample.

Advantageously, the method of the present invention can be applied to the determination of the enantiomeric composition of a variety of chiral compounds. Some suitable examples of chiral compounds whose enantiomeric composition can be determined through the method of the present invention are chiral nitrogen-based nucleophiles, chiral oxygen-based nucleophiles and chiral sulphur-based nucleophiles. Some suitable examples of nitrogen-based nucleophiles whose enantiomeric composition can be determined through the method of the present invention are nitrogen-based nucleophiles selected from the group consisting of chiral amines, chiral aminoalcohols, chiral aminoesters, chiral aminoacids and chiral azasugars.

The chiral compounds whose enantiomeric composition can be determined through the method of the present invention have at least one chiral center. The enantiomeric composition of chiral compounds with more than one chiral center can also be determined through the method of the present invention. In a preferred embodiment of the present invention, the chiral compound has at least one chiral center located at alpha position to the donor atom. The term "donor atom" as used herein refers to the atom of the nucleophile which bears an electron pair that can be donated to an electrophile.

In a preferred embodiment of the present invention, the chiral compounds are primary nucleophiles. The term "primary nucleophile" as used herein refers to nucleophiles wherein the donor atom is monosubstituted.

Advantageously, according to the method of the present invention, a variety of analytic techniques can be used to determine the ratio of diastereomers in said mixture. Some suitable techniques are, for example, ¹⁹F-NMR, ¹H-NMR, ¹³C-NMR, liquid chromatography and GC chromatography.

Advantageously, the presence of ¹⁹F, an NMR active heteroatom, in addition to ¹H and ¹³C, in the chiral derivatising reagent according to the present invention, facilitates the analysis of the diastereomeric mixture by NMR techniques.

Some advantages of using NMR techniques to analyse the diastereomeric mixture are the following:
(a) the instrument is available in most laboratories;
(b) an in-depth understanding of the fundamentals of the method is not necessary to apply this method;
(c) a small amount of sample is needed, and this can be recovered; and
(d) because the analysis is conducted in solution, it is applicable to both solid and liquid samples.

Surprisingly, the method of the present invention yields a diastereomeric mixture wherein all three distinct nuclei present at the fluoride bearing chiral center (namely H, C and F) are substantially differentially perturbed depending on the configuration of the at least one chiral center of the starting chiral compound. As a consequence thereof, substantially different sets of signals for each diasteroisomer are obtained in the ¹H, ¹³C- and ¹⁹F spectra. Moreover, it is surprising that the long-range effect (at least 4 sigma bonds) produced by the stereochemistry of the at least one chiral center of the starting chiral compound on the fluoride bearing chiral center, is able to produce such clear signal separations for each diastereomer in the NMR spectra.

It must be pointed out that not only the nuclei present at the fluoride bearing group but also other nuclei are differently perturbed depending on the configuration of the at least one chiral center of the starting chiral compound, so that substantially different spectra are obtained for each diastereomer.

In a preferred embodiment of the present invention, ¹⁹F-NMR is used as analytic technique to determine the ratio of diastereomers in the final mixture according to the second step of the method of the present invention. Advantageously, if no fluoride atom is present in the aromatic ring and in the starting chiral compound, only two sets of separated signals appear in the ¹⁹F-NMR spectra. Moreover, said two sets of separated signals are substantially remote from those due to the starting fluoroepoxide compound of general formula I. Surprisingly, according to this preferred embodiment of the present invention, clearly separated signals for each diastereomer in the ¹⁹F-NMR spectra are obtained. These signals allow and easy integration and, hence, a simple evaluation of diastereomeric (enantiomeric) composition.

Advantageously, according to this preferred embodiment of the present invention, it is not necessary to use stoichiometric amounts of the compound of general formula I with respect to the chiral compound to be analyzed. Said advantage is due to the fact that no kinetic resolution takes place during the derivatisation step, and since the diagnostic ¹⁹F-NMR signals of the diastereomeric mixture occur in a clean spectral region.

In another preferred embodiment of the present invention, ¹H-NMR is used as analytic technique to determine the ratio of diastereomers in the final mixture according to the second step of the method of the present invention. Surprisingly, according to this preferred embodiment of the present invention, clearly separated signals for the fluoride bearing methyne of each diastereomer are obtained in the ¹H-NMR spectra. These differential signals show good line separation and appear in a clean zone of the spectra and therefore, their integration is easy and reliable. However, it must be pointed out that other NMR signals are also suitable for the determination of the final diastereomeric composition of the diastereomeric mixture (and thus the enantiomeric composition of the starting chiral compound), according to the method of the present invention.

In another preferred embodiment of the present invention, ¹³C-NMR is used as analytic technique to determine the ratio of diastereomers in the final mixture according to the second step of the method of the present invention. Surprisingly, according to this preferred embodiment of the present invention, clearly separated signals for the fluoride bearing methyne of each diastereomer are obtained in the ¹³C-NMR spectra. These differential signals show good line separation and appear in a clean zone of the spectra and therefore, their integration is easy and reliable. However, it must be pointed out that other NMR signals are also suitable for the determination of the final diastereomeric composition of the diastereomeric mixture (and thus the enantiomeric composition of the starting chiral compound), according to the method of the present invention.

In another preferred embodiment of the present invention, HPLC is used as analytic technique to determine the ratio of diastereomers in the final mixture according to the second step of the method of the present invention. Advantageously, the presence of the aromatic or heteroaromatic group, which are UV-active groups, in the chiral derivatising reagent according to the present invention, allows the simple detection by a UV-Vis detector in conventional HPLC. However, other detectors can be also used according to this preferred embodiment of the present invention. Surprisingly, according to this preferred embodiment of the present invention, each diastereomer show substantially different retention times in the HPLC analysis, so that they can be easily separated and quantified. Therefore, the determination of the diastereomeric composition of the final diastereomeric mixture (and thus the enantiomeric composition of the starting chiral compound), according to the method of the present invention is very straightforward.

The invention also refers to the use of an enantiomerically and diastereomerically pure compound of general formula I as a chiral derivatising reagent. 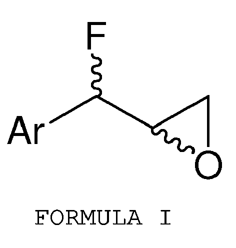 wherein Ar is an optionally substituted aromatic or heteroaromatic group.

In a preferred embodiment of the present invention, said compound of general formula I is selected from the group consisting of
(*S*)-2-((*R*)-fluoro(phenyl)methyl)oxirane,
(*R*)-2-((*S*)-fluoro(phenyl)methyl)oxirane,
(*S*)-2-((*S*)-fluoro(phenyl)methyl)oxirane and
(*R*)-2-((*R*)-fluoro(phenyl)methyl)oxirane.

A further advantage of the method according to the present invention is that the synthesis of compounds of general formula I is very straightforward.

In a preferred embodiment of the present invention, an enantiomerically and diastereomerically pure compound of general formula II is used as chiral derivatising reagent.

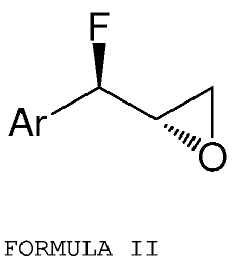

Advantageously, compounds of general formula II can be readily prepared from compounds of general formula III by a preparation process which comprises
(a) reacting compound of general formula III 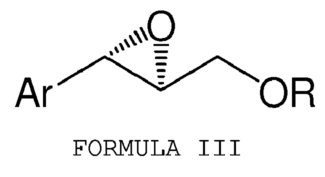
wherein R is a leaving group,
with a fluoride source and (b) reacting the resulting product with a base.

The term "leaving group" as defined herein refers to a substituent group present in the substrate that can be detached from the substrate through a displacement reaction. Some examples of suitable leaving groups are tosylate, mesylate, triflate and acetate.

The term "fluoride source" as defined herein refers to a compound which has the ability to release fluoride.

Advantageously, the preparation process of compounds of general formula II according to the present invention is regioselective and stereospecific.

Alternatively, in a further preferred embodiment of the present invention, an enantiomerically and diastereomerically pure compound of general formula IV is used as chiral derivatising reagent.

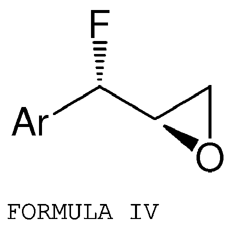

Advantageously, compounds of general formula IV can be readily prepared from compounds of general formula V by a preparation process which comprises
(a) reacting compound of general formula V 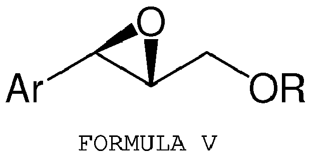
wherein R is a leaving group,
with a fluoride source and (b) reacting the resulting product with a base.

Some examples of suitable leaving groups are tosylate, mesylate, triflate and acetate.

Advantageously, the preparation process of compounds of general formula III according to the present invention is regioselective and stereospecific.

Alternatively in a further preferred embodiment of the present invention, an enantiomerically and diastereomerically pure compound of general formula VI is used as chiral derivatising reagent.

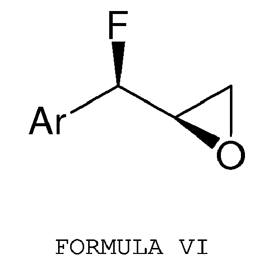

Advantageously, compounds of general formula VI can be readily prepared from compounds of general formula III by a preparation process which comprises
(a) reacting compound of general formula III 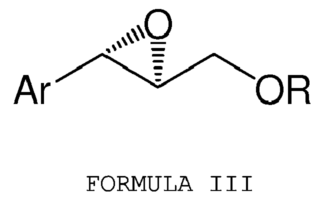 wherein R is a leaving group,
   with a fluoride source, yielding the corresponding (2R, *3R*)-3-fluoro-2-hydroxy-3-arylpropyl derivative,
(b) inverting the configuration of the hydroxyl bearing chiral center by a suitable regioselective and stereospecific method. Such methods have been described in the background art and are widely known by skilled persons in the art. An example of suitable inversion method is the Mitsunobu reaction and subsequent selective hydrolysis or selective reduction (O. Mitsunobu, Synthesis, 1981, 1-28), and
(c) reacting the resulting product with a base.

Some examples of suitable leaving groups are tosylate, mesylate, triflate and acetate.

Advantageously, the preparation process of compounds of general formula VI according to the present invention is regioselective and stereospecific.

Alternatively in a further preferred embodiment of the present invention, a compound of general formula VII is used as chiral derivatising reagent.

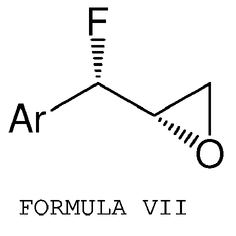

Advantageously, compounds of general formula VII can be readily prepared from compounds of general formula V by a preparation process which comprises
(a) reacting compound of general formula V 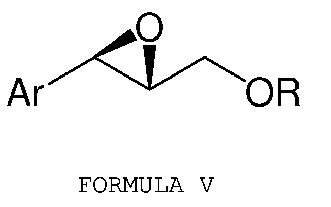 wherein R is a leaving group,
   with a fluoride source, yielding the corresponding (*2S, 3S*)-3-fluoro-2-hydroxy-3-arylpropyl derivative,
(b) inverting the configuration of the hydroxyl bearing chiral center by a suitable regioselective and stereoespecific method. Such methods have been described in the background art and are widely known by skilled persons in the art. An example of suitable inversion method is the Mitsunobu reaction and subsequent selective hydrolysis or selective reduction, and
(c) reacting the resulting product with a base.

Some examples of suitable leaving groups are tosylate, mesylate, triflate and acetate.

Advantageously, the preparation process of compounds of general formula VII according to the present invention is regioselective and stereospecific.

In summary, the readily available enantiopure fluoroepoxides of general formula I have shown to be most convenient chiral derivatising reagents for the fast and reliable determination of enantiomeric composition of a variety of chiral compounds.

Additional objects, advantages and features of the invention will become apparent to those skilled in the art upon examination of the description or may be learned by practice of the invention. The following examples and drawings are provided by way of illustration and are not intended to limit the scope of the invention. It is intended that the scope of the present invention be defined by the claims appended hereto.

### Brief description of the drawings

Fig 1 is the HPLC analysis of the 34.7:65.3 diastereomeric mixture **3a** obtained from the enantiomeric mixture 34.7:65.3 of **(***R***)-2a** and **(***S***)-2a** through the method of the present invention.
Fig 2 is the HPLC analysis of compound **(***S***)-3a** obtained from enantiopure compound **(***S***)-2a** through the method of the present invention.
Fig 3 shows the ¹H-NMR spectra of the CHF region of the 44:56 diastereomeric mixture **3a** obtained from a enantiomeric mixture 44:56 of **(***R***)-2a** and **(***S***)-2a** through the method of the present invention (above), and the ¹H-NMR spectra of the CHF region of compound **(***S***)-3a,** obtained from enantiopure compound **(***S***)-2a** through the method of the present invention (bottom).
Fig 4 shows the ¹³C-NMR spectra of the CHF region of the 44:56 diastereomeric mixture **3a** obtained from a enantiomeric mixture 44:56 of **(***R***)-2a** and **(***S***)-2a** through the method of the present invention (top), and the ¹³C-NMR spectra of the CHF region of compound **(S)-3a**, obtained from enantiopure compound **(***S***)-2a** through the method of the present invention (bottom).
Fig 5 shows the ¹⁹F-NMR spectra of the CHF region of the 65:35 diastereomeric mixture **3a** obtained from a enantiomeric mixture 65:35 of **(***R***)-2a** and **(***S***)-2a** through the method of the present invention (top), and the ¹⁹F-NMR spectra of the CHF region of compound **(***S***)-3a,** obtained from enantiopure compound **(***S***)-2a** through the method of the present invention (bottom).

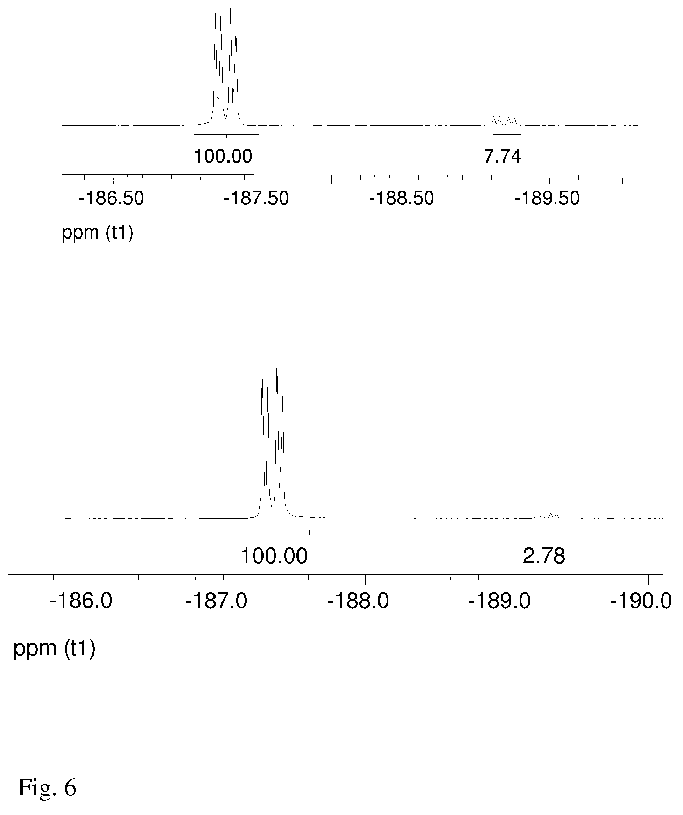

Fig 6 depicts the ¹⁹F-NMR spectra of a 85% (top) and 95% (bottom) diastereomeric mixture of **3a** obtained from 85 % and 95% ee, respectively, of compound **2a,** through the method of the present invention.
Fig 7 is the ¹H-NMR spectrum of the diastereomeric mixture **3d** obtained from a racemic mixture of compound **2d** through the method of the present invention.
Fig 8 is the ¹H-NMR spectrum of compound **(***S***)-3d** obtained from enantiopure compound **(***S***)-2d** through the method of the present invention.
Fig 9 is the ¹³C-NMR spectrum of the diastereomeric mixture **3d** obtained from a racemic mixture of compound **2d** through the method of the present invention.
Fig 10 is the ¹³C-NMR spectrum of enantiopure compound **(***S***)-3a** obtained from a enantiomeric mixture 44:56 of **(***R***)-2a** and **(***S***)-2a** through the method of the present invention.
Fig 11 is the ¹⁹F spectrum of the diastereomeric mixture **3d** obtained from a racemic mixture of compound **2d** through the method of the present invention.
Fig 12 is the ¹⁹F spectrum of compound **(***S***)-3d** obtained from enantiopure compound **(***S***)-2d** through the method of the present invention.

### Detailed description of particular examples

### I) Preparation of enantiomerically and diastereomerically pure derivatisation reagent (S)-2-((R)-fluoro(phenyl)-methyl) oxirane 1

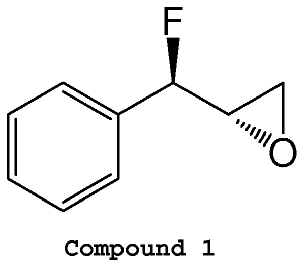

(2*S,* 3*S*)-phenylglycidil *p*-toluensulfonate (0,69 g; 2.27 mmol) was solved in CH₂Cl₂ in a dried 50 ml roundbottomed flask, under inert atmosphere. After cooling the flask to -35°C, BF₃·E₂O was added (0.11 g; 0.75 mmol) and the mixture was stirred at said temperature for one hour. Afterwards, 15 ml of a saturated solution of NaHCO₃ were added and the mixture was extracted with CH₂Cl₂ (3X15 ml). The organic fraction was dryed over anhydrous MgSO₄, the solvent was removed under vacuum, and the oil was purified by liquid chromatography with a mixture hexane:AcOEt (9:1 to 8:2) as elutant.

The resulting (2*S,* 3*R*)-3-fluoro-2-hydroxy-3-phenylpropyl *p*-toluen-sulfonate (10.0 mmol, 3.24 g) was dissolved in 10 mL of anhydrous THF in a flame-dried flask, and treated with 10 mL of 1 M lithium tert-butoxide in THF. After 30 minutes, the reaction was quenched with 20 mL of water and extracted with CH₂Cl₂ (3x15 mL). The organic extracts were dried (Na₂SO₄), and solvents removed off *in vacuo* to afford **1** in quantitative yield.
¹H NMR (CDCl₃, 400 MHz): δ 7.34-7.45: (5H, m, Ar*H*) , 5.13 (1H, dd, ³J_{HH} = 6,3 Hz, ²J_{HF} = 47,2 Hz, C*H*F) , 3.35 (1H, m, C*H*O) , 2.89 (1H, ddd, ⁴J_{HF} = 4.2 Hz, ³J_{HH} = 4.2 Hz, ²J_{HH} = 4.7 Hz, C*H*HO) , 2.88 (1H, ddd, ⁴J_{HF} = 1.6 Hz, ³J_{HH} = 2.6 Hz, ²J_{HH} = 4.8 Hz, CH*H*O) ppm.
¹³C {¹H} NMR (CDCl₃, 100 MHz) : δ 136,04 (d, ²J_{CF} = 21.2 Hz), 129.07 (d, ⁴J_{CF} = 2.2Hz), 128.66, 126.00 (d, ³J_{CF} = 6.6Hz), 94.62 (d, ¹J_{CF} = 175.7 Hz), 53.62 (d, ²J_{CF} = 27.9 Hz) , 44.18 (d, ³J_{CF} = 8.1 Hz) ppm.
¹⁹F NMR (CDCl₃, 470.5 MHz): δ-180, 96 (d, ²J_{FH}=46.8 Hz) ppm.
[α]²⁷_{D} -20.9 (c = 1.01, CHCl₃).
MS (EI⁺) : m/z 152 (35%, M⁺), 109 (100%, C₇H₆F).

### II. Determination of the enantiomeric composition of different known samples of chiral compound 2a by using fluoroepoxide 1 as chiral derivatising reagent

### IIa. Derivatisation reaction

The general procedure for the derivatisation of different samples of **2a** was the following: 4.1 mg (0.0265 mmol) of fluoroepoxide **1**, and 28.4 mg (0.265 mmol) of LiClO₄ were weighted in the microwave reactor vessel, which was purged with argon, and dissolved in 1.5 mL of dry THF. Then, 490 µL of a 0.55 M solution (0.270 mmol) of amine in THF were added. The mixture was heated at 75 °C using microwaves for 20 minutes. After cooling down to r.t., water was added to the vessel, and the mixture was extracted with CH₂Cl₂ (x3), dried (Na₂SO₄), and the solvents removed *in vacuo.* The resulting crude was analyzed by ¹⁹F-NMR, ¹H-NMR or ¹³C-NMR using CDCl₃ as solvent, or alternatively, by HPLC.

To ensure that no kinetic resolution happened during the performance of the derivatisation reaction according to the method of the present invention, the reaction crudes were analyzed at different conversion levels. In all cases, the ring-opening product was a perfect 1:1 mixture of diastereomers. In addition, the use of either enantiopure or racemic amines led to the same yields of ring-opening products under identical conditions. Therefore, these results confirm that no kinetic resolution takes place during the performance of the method of the present invention.

### IIb. Applicability of the method for the determination of the enantiomeric composition of chiral compounds according to the present invention

The yield, the main NMR signals associated to the CHF group and the HPLC retention times for the diastereomers **(*R*)-3a** and **(*S*)-3a,** obtained by reaction of chiral compound **(*R*)-2a** and **(*S*)-2a,** respectively, with the chiral derivatising reagent **1**, are summarized in table 1.

**Table 1.**

| **Chiral amine analysed** | **Diastereomer formed through the derivatisation reaction (yield)** | **NMR analysis δ [ppm] -CHF-** | **HPLC^{a} analysis t_{R} (min)** |
|---|---|---|---|
| 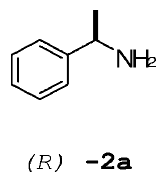 | 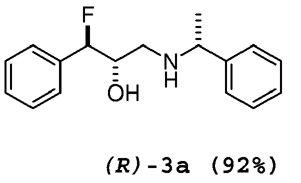 | ¹⁹F: -188.8 ¹H: 5.38 ¹³C: 95.8 | 14.6 |
| 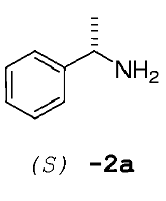 | 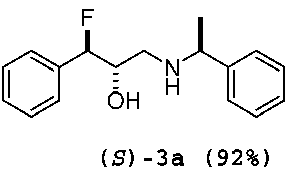 | ¹⁹F: -186.8 ¹H: 5.33 ¹³C: 95.7 | 16.6 |

| | | | |
|---|---|---|---|
| ^{a} Zorbax-Sil column; eluent hexane:2-propanol (0.1% Et₂NH) 99:1, flow 1.0 ml/min. | | | |

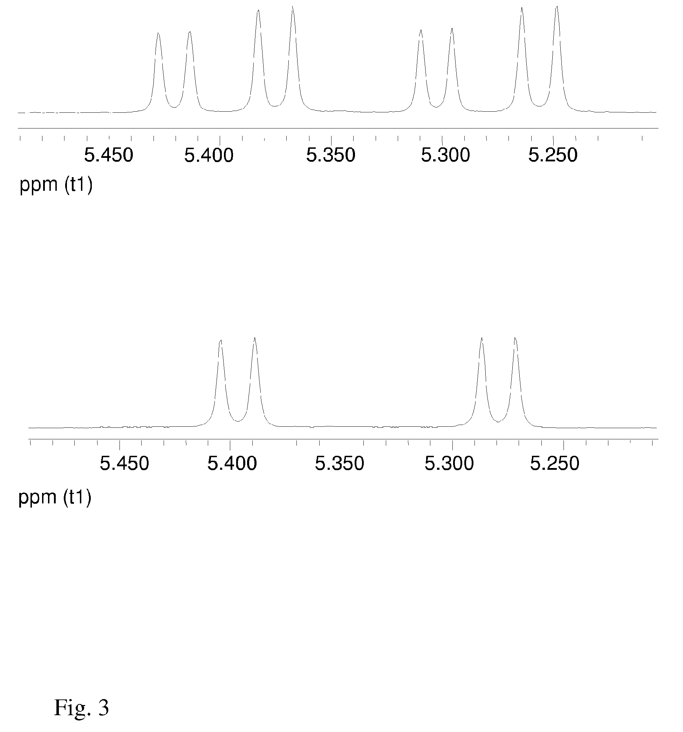

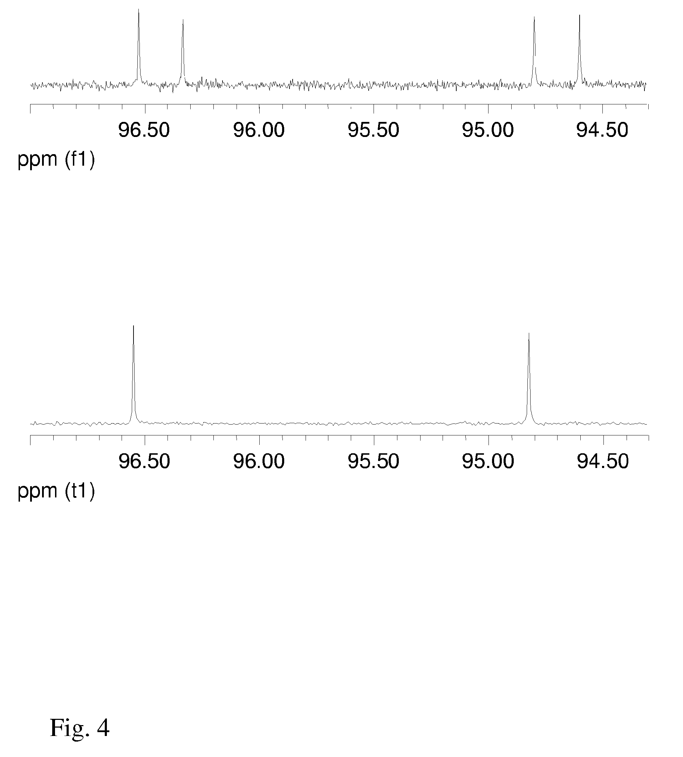

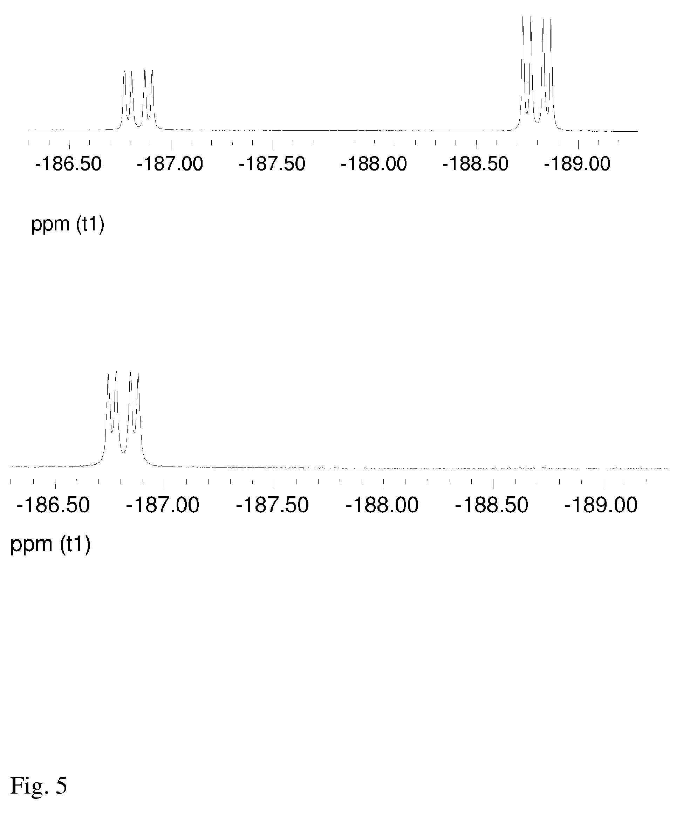

Figures 3 to 5 show the CHF region of the ¹H, ¹³C and ¹⁹F NMR spectra of a mixture of diastereomers of **3b** (in variable proportions) as compared to the corresponding spectra of the diastereomer **(***S***)-3b.**

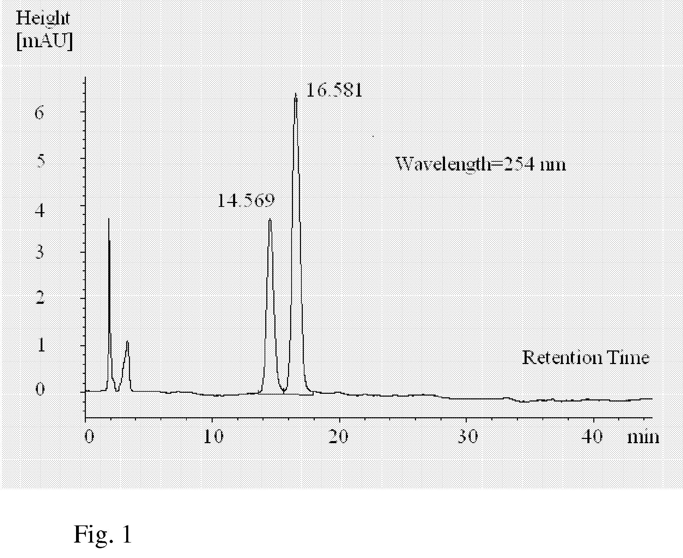

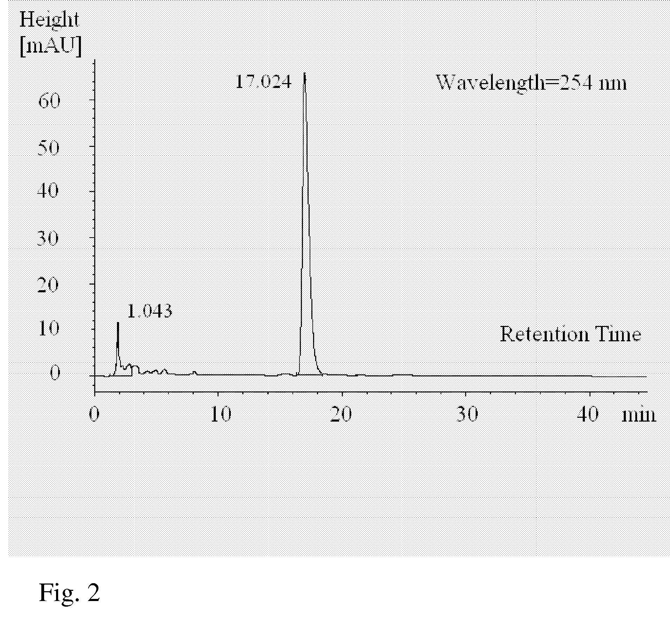

It is clear from table 1 and figures 3 to 5 that substantially separated sets of signals are observed for the CHF moiety of each diastereomer in the ¹H, ¹³C and ¹⁹F NMR spectra, making their integration easy and reliable. On the other hand, the HPLC retention times corresponding to each diastereomer also present good separation and allow their integration in an easy and reliable way (see Figure 1 and Figure 2).

Therefore, the method of the present invention allows the substantially good separation of signals corresponding to each diastereomer by using different analytic techniques.

### IIc. Sensibility and accuracy of the method for the determination of the enantiomeric composition of chiral compounds according to the present invention

Different samples of compound **2a** with variable enantiomeric excesses were prepared by weighting. Table 2 shows the enantiomeric compositions determined through the method of the present invention for each known sample of compound **2a** by using different analytic techniques.

**Table 2**

| **method** | **0% ee** | **86.6% ee** | **95.7% ee** |
|---|---|---|---|
| HPLC^{a} | 0 | 85.0 | 95.7 |
| ¹⁹F-NMR | 0 | 85.6 | 94.6 |
| ¹H-NMR | 0 | - | - |
| ¹³C-NMR | 0 | - | - |

| | | | |
|---|---|---|---|
| ^{a} Zorbax-Sil column; eluent hexane:2-propanol (0.1% Et₂NH) 99:1, flow 1.0 ml/min. | | | |

These results show that enantiomeric compositions up to 95% have been efficiently determined with less than 2% error through the method of the present invention, by any of the analytic techniques employed. Therefore, the method for the determination of enantiomeric excesses according to the present invention shows high sensibility and accuracy.

### III. Derivatisation and analysis of racemic mixtures of various chiral amines according to the method of the present invention

The general procedure used for the preparation of compounds **3b** to **3h,** except for **3f** (see table 3), was the following: 4.1 mg (0.0265 mmol) of fluoroepoxide **1,** and 28.4 mg (0.265 mmol) of LiClO₄ were weighed in the microwave reactor vessel, which was purged with argon, and dissolved in 1.5 mL of dry THF. Then, 490 µL of a 0.55 M solution (0.270 mmol) of amine in THF were added. The mixture was heated at 75 °C using microwaves for 20 minutes. After cooling down to r.t., water was added to the vessel, and the mixture was extracted with CH₂Cl₂ (x3), dried (Na₂SO₄), and the solvents removed *in vacuo.* The resulting crude was analyzed by ¹⁹F-NMR, ¹H-NMR or ¹³C-NMR using CDCl₃ as solvent, or alternatively, by HPLC.

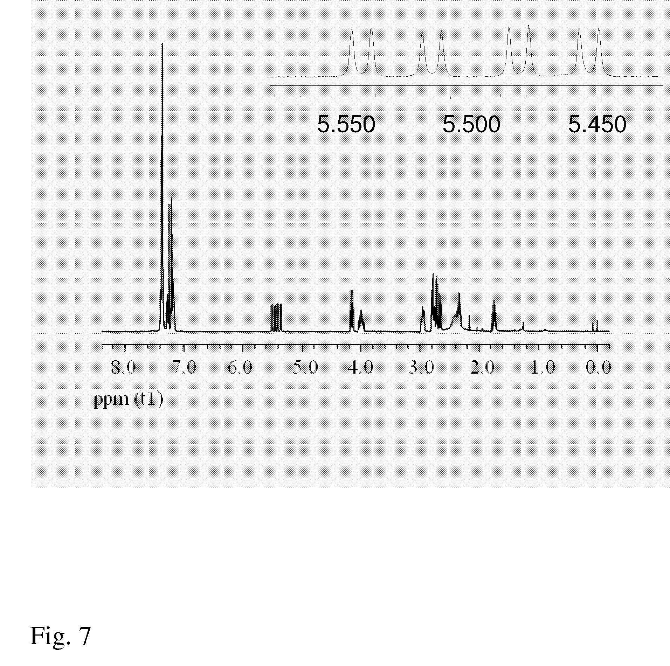

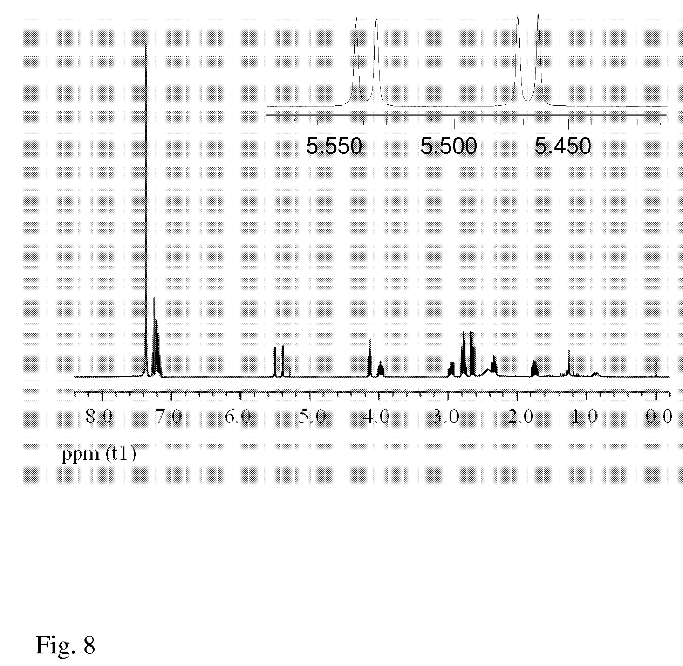

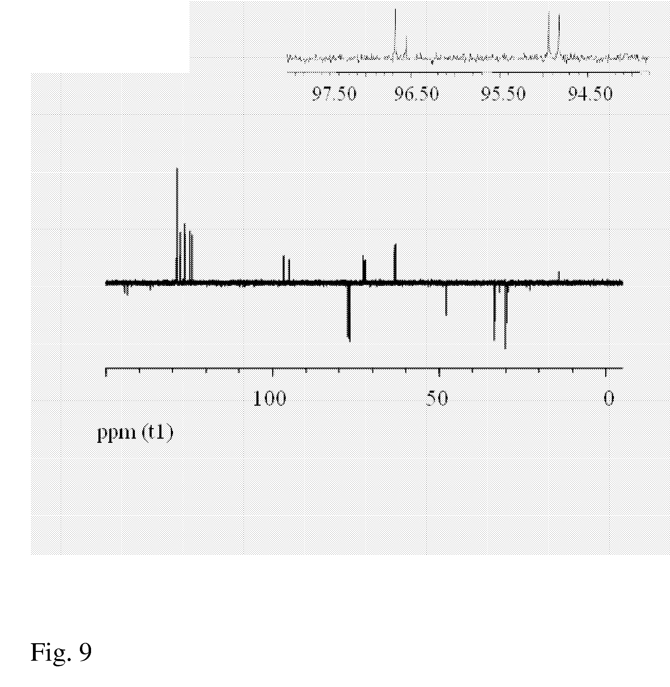

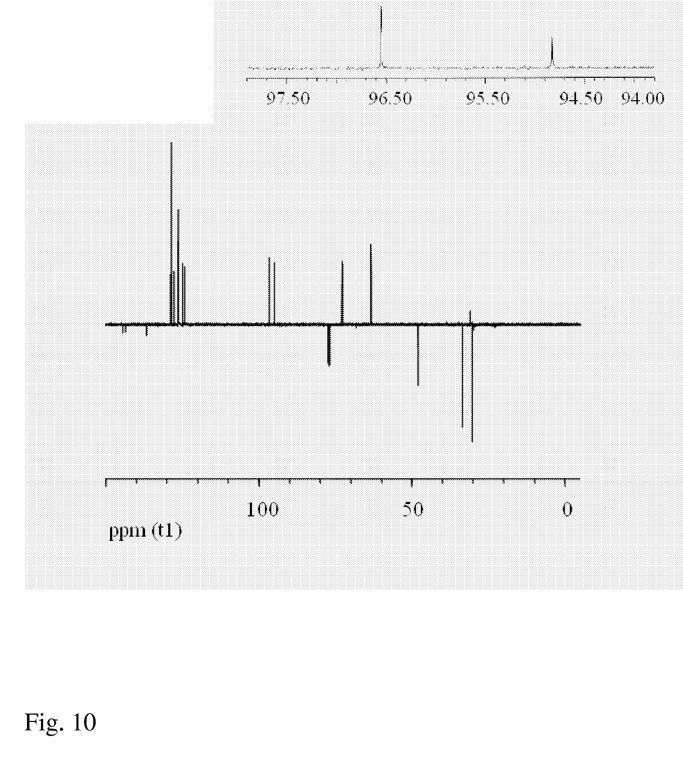

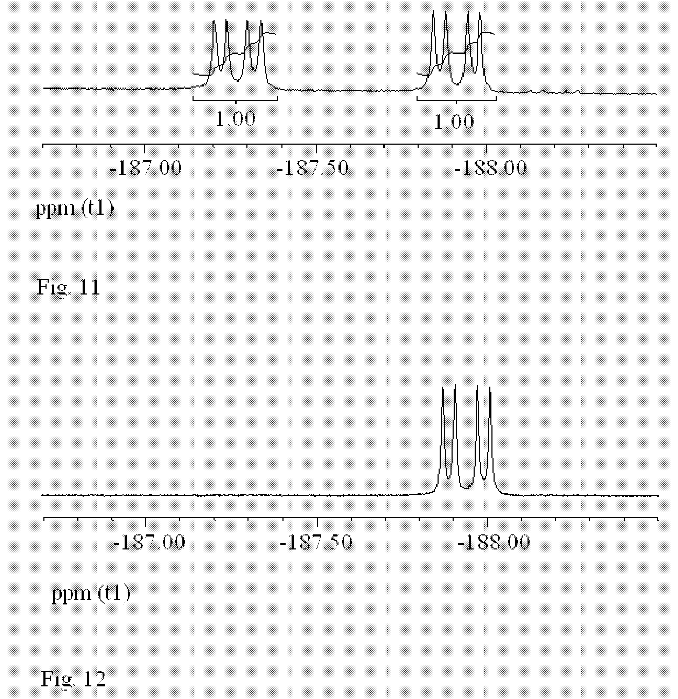

The yield, main NMR signals associated to the CHF group and HPLC retention times of the 50:50 diastereomer mixture obtained by reaction of racemic amines 2b to 2h with the enantiomerically and diastereomerically pure derivatising reagent **1** are summarized in Table 3. As an example of signal separation, the ¹H, ¹³C and ¹⁹F spectra of **3d** obtained from racemic **2d** and from **(*S*)-2a** are shown in Figures 7 to 12 (together with an amplification of the CHF region). Slight shift differences observed in the ¹H-NMR spectrum of the racemic mixture as compared to the corresponding spectra of the enantiopure compound are due to the fact that the spectra were recorded at 500 Hz and 400 Hz, respectively.

**Table 3**

| | Chiral compound | Product (yield [%]^{a}) | NMR analysis δ [ppm] CHF | HPLC analysis t_{R} [min] |
|---|---|---|---|---|
| *rac*-2b | 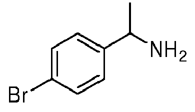 | 3b (83) | ¹⁹F: -185.8; -188.2 ¹H: 5.35; 5.32 ¹³C: 95.8; 95.6 | 18.1; 21.1^{b} |
| *rac*-2c | 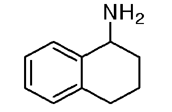 | 3c (77) | ¹⁹F: -187.1; -188.6 ¹H: 5.49; 5.45 ¹³C: 95.8; 95.6 | 17.5; 19.0^{b} |
| *rac*-2d | 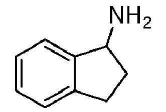 | 3d (80) | ¹⁹F: -187.3; -187.9 ¹H: 5.46; 5.40 ¹³C: 95.9; 95.7 | 10.7; 14.4^{b} |
| *rac*-2e | 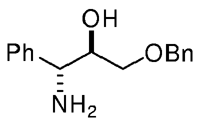 | 3e (74) | ¹⁹F: -183.5; -186.0 ¹H: 5.43; 5.33 ¹³C: 95.8; 95.4 | 12.6; 16.0^{b} |
| *rac*-2f | 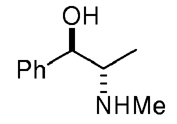 | 3f (3)^{d} | ¹⁹F: -185.2; -185.9 ¹H: 5.19; 5.17 ¹³C: 95.3; 95.2 | 10.7; 13.5^{b} resolved |
| *rac*-2g | 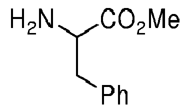 | 3g (70) | ¹⁹F: -188.9; -189.1 ¹H: 5.31; 5.22 ¹³C: 95.4; 95.3 | 25.38; 25.98^{c} |
| *rac*-2h | 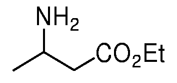 | 3h (72) | ¹⁹F: -187.0; -187.1 ¹H: 5.38; 5.37 ¹³C: 95.9; 95.8 | 22.81; 23.63^{c} |

| | | | | |
|---|---|---|---|---|
| ^{a} Isolated yield after flash chromatography. ^{b} Zorbax-Sil column; elutant hexane:2-propanol (0.1% Et₂NH) 99:1, flow 1.0 ml/min. ^{c} HPLC/MASS (column Waters Atlantis dC18, 3um, 2.1*150mm, eluent MeOH/H₂O; 5% to 100% in 30 min hold for 15 min, flow 0.2ml/min, injection volume 10ul, MS detection +ve ESI, extracted ion : (M+Na) ^{d} 10 mol% Cu(BF₄)₂. 6H₂O, acetonitrile, 2h, 75 °C (MW) | | | | |

From a preparative point of view, the derivatisation reaction worked nicely for different primary amines. Even a more functionalyzed substrate like **2e,** also containing an alcohol and ether functions could successfully be derivatised. Racemic ephedrine **2f** could be used as substrate as well, showing that secondary amines with extra functional groups (alcohol) are able to react with fluoroepoxide 1. α- and β-amino acid derivatives (products 3g and **3h**) were suitable substrates as well.

Substantially good signal separations are observed for the CHF moiety in the ¹H, ¹³C and ¹⁹F-NMR spectra of each mixture of diastereomers. In the same manner, each mixture of diastereomers showed good separation of the HPLC retention times. Although not specified, it must be pointed out that other NMR signals (different to the set of signals corresponding to the CHF moiety) were also suitable for the determination of the diastereomeric (enantiomeric) compositions.

The enantiomeric compositions of the different chiral compounds depicted in Table 3 were determined to be 50-50 (0% ee) according to the method of the present invention. These values corresponded exactly to the known enantiomeric compositions of said samples established by weighting.

As a conclusion, the enantiomeric composition of a wide variety of nitrogen containing compounds could be efficiently determined through the method of the present invention.

## Claims

1. A method for the determination of the enantiomeric composition of a chiral compound comprising
(a) derivatising said chiral compound with a enantiomerically and diastereomerically pure compound of general formula I 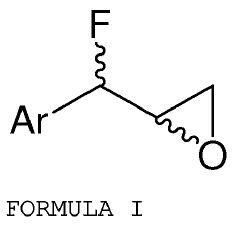 wherein Ar is an optionally substituted aromatic or heteroaromatic group and
(b) analysing the resulting mixture by an analytic technique.

2. A method according to claim 1, wherein said analytic technique is selected from the group consisting of ¹⁹F-NMR, ¹H-NMR, ¹³C-NMR and chromatography.

3. The method according to claim 1 or claim 2, wherein said compound of general formula I is selected from the group consisting of (*S*)-2-((*R*)-fluoro (phenyl) methyl) oxirane,
(*R*)-2-((*S*)-fluoro(phenyl)methyl)oxirane,
(*S*)-2-((*S*)-fluoro(phenyl)methyl)oxirane and
(*R*)-2-((*R*)-fluoro(phenyl)methyl)oxirane.

4. The method according to any of claims 1 to 3, wherein said chiral compound is selected from the group consisting of chiral nitrogen-based nucleophiles, chiral oxygen-based nucleophiles and chiral sulphur-based nucleophiles.

5. The method according to claim 4, wherein said chiral compound is a chiral nitrogen-based nucleophile selected from the group consisting of chiral amines, chiral aminoalcohols, chiral aminoesters, chiral aminoacids or chiral azasugars.

6. The method according to claim 4 or 5, wherein said chiral compound is a primary nucleophile.

7. The method according to any of claims 4 to 6, wherein the chiral compound has at least one chiral center located at alpha position to the donor atom.

8. The method according to any of claims 1 to 7, wherein the reaction of said chiral compound with said compound of general formula I is performed in the presence of a promoter.

9. The method according to claim 8, wherein said promoter is a Lewis acid.

10. The method according to any of claims 1 to 9, wherein the reaction of said chiral compound with said compound of general formula I is performed under microwave irradiation.

11. Use of an enantiomerically and diastereomerically pure compound of general formula I as a chiral derivatising reagent. 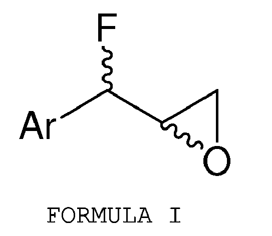 wherein Ar is an optionally substituted aromatic or heteroaromatic group.
